(19) **Europäisches Patentamt / European Patent Office / Office européen des brevets**

(11) **EP 2 239 848 A2**

(12) **EUROPEAN PATENT APPLICATION**

(43) Date of publication:
**13.10.2010 Bulletin 2010/41**

(51) Int Cl.:
*H03K 5/1252* (2006.01)     *H03K 19/003* (2006.01)
*H03K 19/20* (2006.01)

(21) Application number: **10164724.6**

(22) Date of filing: **28.08.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **03.09.2007 US 849312**

(62) Document number(s) of the earlier application(s) in accordance with Art. 76 EPC:
**08789120.6 / 2 186 195**

(71) Applicants:
• **Bainbridge, John**
  **4 Ashdene Road**
  **Withington**
  **Manchester M20 4RZ (GB)**
• **Salisbury, Sean**
  **Appley Bridge**
  **Lancashire WN6 9JP (GB)**

(72) Inventors:
• **Bainbridge, John**
  **4 Ashdene Road**
  **Withington**
  **Manchester M20 4RZ (GB)**
• **Salisbury, Sean**
  **Appley Bridge**
  **Lancashire WN6 9JP (GB)**

(74) Representative: **Maggs, Michael Norman et al**
  **Kilburn & Strode LLP**
  **20 Red Lion Street**
  **London WC1R 4PJ (GB)**

Remarks:
This application was filed on 02-06-2010 as a divisional application to the application mentioned under INID code 62.

(54) **Hardening of self-timed circuits against glitches**

(57)     Multiple techniques are disclosed for hardening a self-clocking circuit against glitches. Glitch filters are placed in some portions of a digital design. In some embodiments the glitch filter is dynamically tunable. In one embodiment the inputs are locked out by the outputs. Methods for evaluating code symbols are presented, as is a circuit for differential signaling.

**EP 2 239 848 A2**

**Description**

BACKGROUND

Asynchronous circuits, often referred to as "clockless circuits" or "self-timed" circuits offer many advantages over synchronous circuits when used in digital logic comprising electronic products, such as integrated circuits. A significant advantage of asynchronous circuits is lower power compared to the same function implemented using synchronous design techniques. Historically, synchronous designs have been more widely used than asynchronous designs, partly due to such factors as smaller die area required, easier and better understood testing capability, and wider availability of design tools.

Synchronous circuits determine specific times for a circuit to evaluate (and respond) to input conditions. For example, synchronous circuits often utilize a dock signal to enable/disable the acceptance of data signals ("docking in") into the input(s) of a synchronous logic gate. Any erroneous signals on the input lines during non-clocking periods are not known to the logic gate and therefore have no effect on the behavior of the gate.

In contrast, by definition clockless circuits respond asynchronously to input signals and may, under certain conditions, respond to any signal change at a gate input wherein the signal change is of a sufficient signal level (e.g., above a transistor threshold voltage) and time duration (e.g., turn-on time of the gate input stage). Thus a glitch, such as a voltage spike, on an input signal line to a clockless circuit may cause an unwanted behavior.

Crosstalk, supply noise, electromagnetic coupling and other sources of electrical disruptions can all cause variations in the propagation delay of signals, and potentially can also cause glitches on signals in a circuit. If a glitch is substantial enough that it equals or exceeds a transistor threshold voltage, and if the glitch lasts for a long enough time duration, then a logical gate Including the transistor may change the value of its output for some combinations of its internal state and the value of other input signals to the logical gate. In a self-timing logic circuit such glitches may result in the transmission of an incorrect state or value or an improper control signal.

Faults may manifest in a variety of ways, depending on which part of a circuit they affect, the instant state of that part of the circuit, and the next proper action that occurs in that part of the circuit. For example, a high-going glitch on an input to a Muller C element when the element is anticipating a logical signal from an upstream Muller C element may cause the element to interpret the glitch as a valid logical HI input signal, causing the element to change its output state, thereby transmitting a HI logical output when it should not. In another example, a plurality of parallel Muller C elements in an RTZ ("return to zero") logical design may be improperly released from a 'wait' condition by a low-going glitch on the signal line controlling the Muller C elements.

Some faults may be propagated through a system until a fault isolation point. An example of this is a fault causing a code symbol to be modified and received as the wrong value, or possibly causing an additional code symbol to be injected. The injected signal is received ahead of the intended symbol and used instead of the intended symbol, pushing the genuine code symbols and all following it a handshake later.

A propagated fault where a code symbol is modified or injected as a result of the fault, and propagates to an isolation point will, if it causes damage, result in the reception of incorrect information.

If a propagated fault affects the message header fields of Network on Chip ("NoC") packets, or the route logic within a network fabric unit, it can result in incorrect route handling for a packet or message. Examples include a packet being routed to the wrong receiver, a packet being truncated, or possibly multiple packets being concatenated together due to an end-of-packet marker being modified so that it isn's recognized

In some cases, a fault may upset the inputs or state holding elements to a state-machine related to handling self-timed communication protocols. This could cause switching to a wrong state which would either cause incorrect operation or possibly cause a protocol to deadlock since the state-machine would no longer be able to correctly communicate with its neighbors.

What is needed is a means for preventing glitches from causing a logical fault in a clockless circuit.

SUMMARY

The present invention comprises a plurality of circuits for improving the hardening of a self-clocking logical block, comprising:

    a. Glitch filters;
    b. Tunable glitch filters;
    c. Signal locking;
    d. Verifying a complete code symbol; and
    e. Complementary signaling including a Muller C element.

All or less than all of the hardening techniques are employed throughout a design or only in selected locations. Glitch filters comprise delay lines in parallel with a line carrying a signal, terminated by a logical element, thereby filtering out narrow pulses. Some embodiments of glitch filters provide means for tuning the delay time of the delay line. Signal lock out provides a latched output back to the input side of the logical block, preventing any change in state until a 'return to zero from an upstream sending block. By verifying a complete code symbol, including assumed to be inactive signal lines, additional faults may be avoided. Differential signaling uses a complementary pair of signal lines and a Muller C gate for a novel technique to harden long lines against glitches by increasing common mode rejection.

BRIEF DESCRIPTION OF THE DRAWINGS

FIG. 1    is a standard symbol for a Muller C logical gate. PRIOR ART.

FIG. 2    shows a circuit block diagram for a Muller C element. PRIOR ART.

FIG. 3    shows an alternative embodiment of a Muller C element. PRIOR ART.

FIG. 4    is an example of self-clocking circuits for transmitting data signals. PRIOR ART.

FIG. 5    shows the relationship between signals and their edge transitions of FIG. 4.

FIG. 6    is a transition signal graph corresponding to FIG. 5 and FIG. 4. FIG. 7 is a glitch filter. PRIOR ART.

FIG. 8    is a glitch filter. PRIOR ART.

FIG. 9    is a glitch filter using a Muller C gate according to the present invention.

FIG. 10    is a tunable glitch filter according to the present invention.

FIG. 11    is an example of glitch filters within a logical block, for example the logical block of FIG. 4.

FIG. 12    shows a circuit for detecting a proper code symbol by evaluating the high signals.

FIG. 13    shows a circuit for detecting a proper code symbol by evaluating all signal terms.

FIG. 14    is a circuit for locking out the inputs to a logical block until an idle state is provided.

FIG. 15    shows a differential signaling method using a Muller C element.

DESCRIPTION OF SOME EMBODIMENTS

Definition of some terms:

| glitch | A surge of current or a spurious electrical signal; also, in extended use, a sudden short-lived írregularity in behavior. |
| --- | --- |
| Q | Symbol used to signify the output terminal of a logical element, such as a flip flop, an AND gate, a Muller C element, and the like. |
| RTZ | Return To Zero. A method of transmitting logical data wherein a signal returns to zero between data bits. |
| NRZ | Non-return To Zero. A method of transmitting logical data wherein a signal is not required to return to zero between data bits. |
| NoC | Network on Chip, an approach to intra-chip communication between logic block wherein networking techniques such as packet switching are used. |

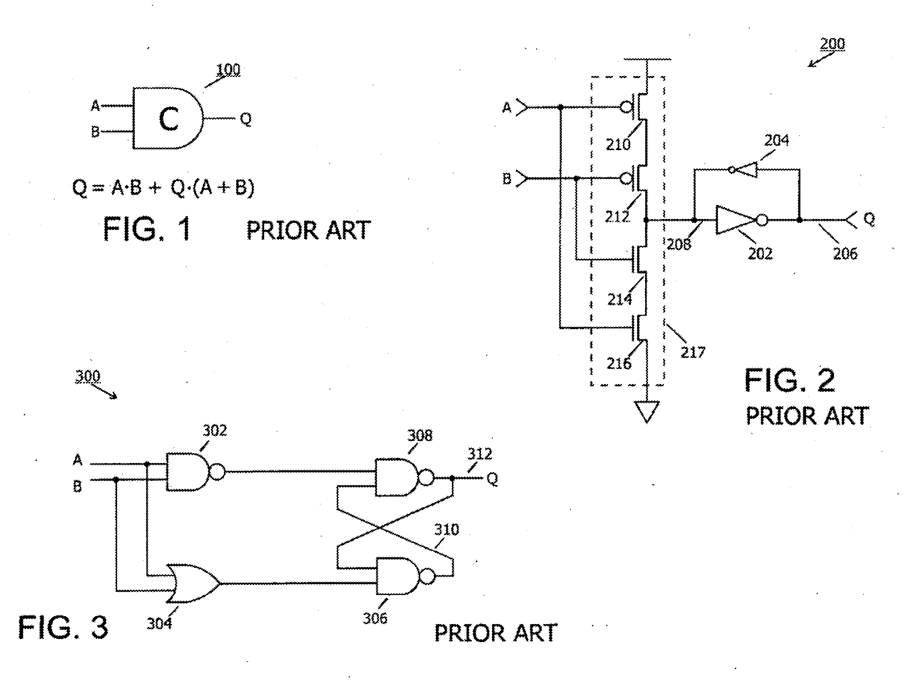

The symbol 100 and logical expression for a "Muller C" element, well known in the art, are shown in FIG. 1.

We will sometimes refer to a Muller C element as a "C-cell" or "C element" interchangeably. FIG. 2 shows a typical embodiment of a Muller C element 200. Examining the circuit diagram, the input signals A and B at their respective input terminals drive a change in state of the output signal Q on line 206, per the logical expression:

$$[1] \qquad Q = A \cdot B + Q \cdot (A + B).$$

The expression [1] may be verbally described by the statement that the output signal Q does not change state unless both signals A and B change to the same state. The signal Q on line 206 corresponds to the output of the stacked FETs 217 on line 208, buffered and inverted by the inverter 202. To preserve the output state of signal Q on line 206 as signals A and B change (but not such that signal Q changes), a weak feedback inverter 204 is connected across the inverter 202. The feedback inverter 204 may also diminish or eliminate glitches on line 206. One skilled in the art will know of other circuits for preserving the state of signal Q on line 206.

The FET stack 217 embodies the term (A·B) of expression [1]. For example, if A=B=1, FETs 210 and 212 will be driven off, FETs 214 and 216 will be driven on, thus the input terminal to inverter 202, connected to a ground signal on line 208, will be pulled down and the output of the inverter 202 will drive high, providing the FET stack 417 output on line 208 is stronger than the weak feedback inverter 204. Similarly, if A=B=0, FETs 210 and 212 will be driven on, and FETs 214 and 216 will be driven off, thus the input terminal to inverter 202, connected to a high voltage signal on line 208, will be driven high and the output of the inverter 202 will drive low, again providing the FET stack 217 output on line 208 stronger than the weak feedback inverter 204. Thus the condition of A=B=1 corresponds to a SET of the cell 200 and the condition of A=B=0 corresponds to a RESET of the cell 200. Any other condition causes no change in the cell 200. For example, if A=1 and B=0, the output of the FET stack 217 will float and the weak feedback inverter 204 will prevent the input signal on line 208 from changing, therefore the inverter 202 output (and Q) do not change. This condition, i.e., preservation of the signal Q when signals A and B are different, embodies the term Q*(A + B) of expression [1].

FIG. 3 is another embodiment of a Muller C element 300. Note that the Muller C element 300 is logically equivalent to the Muller C element 200 in FIG. 2. The behavior of the cell 300 is described by Table 1. The table entries correspond to the input signals A and B, followed by the output of the logic gates corresponding to the reference numbers in FIG. 3. "Q'" indicates that the output of a gate is indeterminate; that is, no change from the previous output signal.

Table 1

| A | B | 302 | 304 | 306 | 308 (Q) |
|---|---|-----|-----|-----|---------|
| 0 | 0 | 1 | 0 | 1 | 0 |
| 0 | 1 | 1 | 1 | Q' | Q' |
| 1 | 0 | 1 | 1 | Q' | Q' |
| 1 | 1 | 0 | 1 | 0 | 1 |

The Muller C elements of FIG. 2 and FIG. 3, then, may be seen to change the state of the output signal Q in response to the states of the signals A and B at whatever time signals A and B become equal. When that occurs is not important. That is, the signals A= B do not have to be provided to the cell inputs at any particular time for the output signal Q to respond. Thus by using various versions of self-timed cells, which may have any number of input terms, and by providing a cell's output signal Q as an input signal to another self-timed element, one may design a logic block that will evaluate to the correct output state for a given state of inputs independent of any predetermined timing clock signal because each component does not change state until its inputs are valid.

A glitch may result in either a valid or an invalid input to a circuit. Validation of data may be performed, for example by software or logic, at the point of final use of a data symbol, though mid-point checking may also be done. Thus, with proper design, an invalid condition caused by a glitch is not fatal to a system, though it may degrade system performance. An invalid condition, by its nature, may be straightforward to detect. More difficult to detect is the condition wherein a glitch causes a gate to receive a valid input condition that is not intended. It is important, therefore, to harden a design to be more resistive to a glitch that results in a valid symbol. To understand this situation we examine the operation of a self-clocking logical design that is operating properly; that is, without errors.

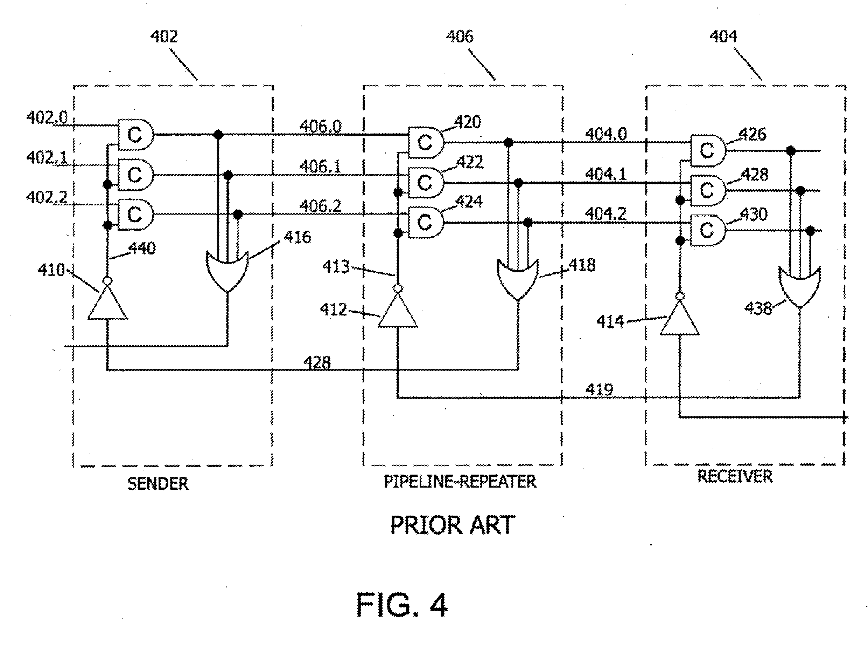

There are many self-clocking design topologies in the art. For the purpose of illustration we discuss a "1 of n" or "one hot" circuit design wherein a return to zero (RTZ) data communications protocol is used. FIG. 4 shows one example of such a circuit. To describe operation, we examine the operation of one gate in detail. FIG. 4 comprises three Muller C-based circuit elements. A sender 402 transmits data to a receiver 404. Though not required, in the example shown a pipeline-repeater 406 simply repeats the data received from the sender downstream to the receiver. Table 2 is a state table for the pipeline-repeater 406, wherein the RTZ symbol protocol is imposed and wherein a single H is the only valid input. The Input numbers refer to signals on the Input lines to gate 404.

Table 2

| Input | | | Result |
|---|---|---|---|
| 404.0 | 404.1 | 404.2 | |
| 0 | 0 | 0 | Idle state |
| 0 | 0 | 1 | 1d |
| 0 | 1 | 0 | 2d |
| 1 | 0 | 0 | 4d |
| 0 | 1 | 1 | Invalid |
| 1 | 0 | 1 | Invalid |
| 1 | 1 | 0 | Invalid |
| 1 | 1 | 1 | Invalid |

Data transport down the data path, comprising the three data lines from 402.n to 404.n, may be thought of as a ripple of data. As a data packet passes from the input side to the output side of a gate the gate acknowledges the activity with an ACK signal to the next most upstream circuit, enabling the upstream circuit to provide the next data packet.

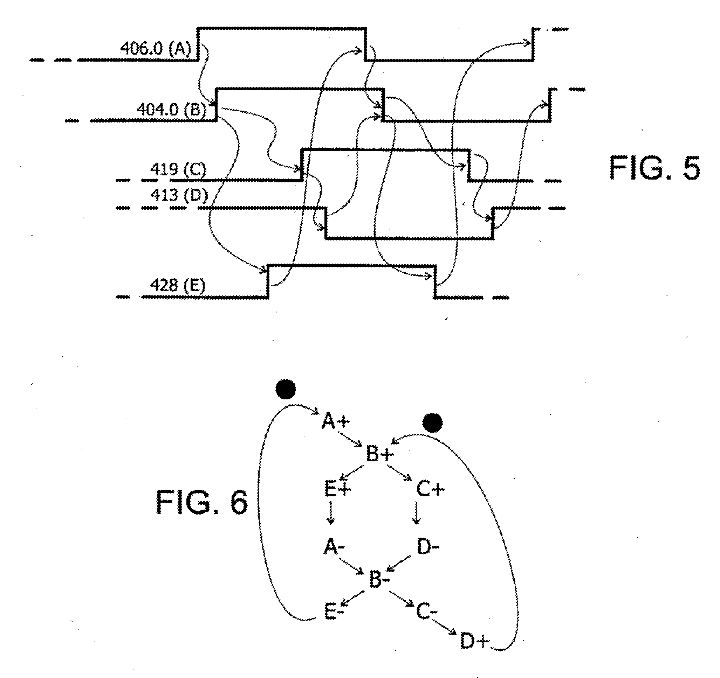

FIG. 5 illustrates the logical sequence associated with the pipeline-repeater gate 406 of FIG. 4. FIG. 6 presents a transition diagram of the interactions of the rising and falling signal edges with respect to the pipelined repeater. The signal numbers in FIG. 5 correspond to the signal lines of the circuit shown in FIG. 4. The letters in parentheses correspond to the same letter in the transition diagram of FIG. 6. A plus sign after a letter symbolizes that the signal is rising and a minus sign after a letter symbolizes that the signal is falling.

For the instant example, consider the symbol "001" being sent by the sender 402 to the receiver 404 through the repeater 406 (assume the line 402.0 is the LSB of any data word). The signal on line 413 is H, providing a H input to each of the Muller C elements 420, 422, 424. As discussed earlier, a Muller C element does not change its output until both inputs become the same value. In the example shown, a RTZ protocol is embodied, therefore the H on line 413 enables elements 420,422, and 424 which are waiting to receive a matching high level signal from the sender 402. Per Table 2, the gate 406 is in an idle state. When the data word {001} is transmitted by the sender 402, the signal on line 406.0 rises (A+). Because the signal on line 413 is high, the data word {001} is passed to the output of the repeater 406 on lines 404.0, 404.1, 404.2 (B+) after a propagation delay. The rising edge of the signal on line 404.0 drives the output of an OR gate 418 high on line 428 (E+). The signal on line 428 is provided back to an inverter 410 in the sender 402, thereby providing an (upstream) ACK signal to sender 402 that the data word has been passed on by repeater 406.

The high signal on line 404.0 (B+) is passed through the next Muller C element 426 (because the output of inverter 414 was also high), thereby driving the OR gate 438 output signal on line 419 high (C+), which signal is inverted by inverter 412, providing a (downstream) ACK from gate 404 to gate 406 (D-). The upstream ACK (the signal on line 428) provides a low input to the Muller C elements of gate 402, thereby notifying sender 402 that the data has been received at the receiver 404, and preparing the Muller C elements of gate 402 for a low input, completing the RTZ requirement of the protocol. When the sender 402, then, provides a data word {000} to the repeater 406 on lines 406.0, 406.1, and 406.2 (A-), the output on line 404.0 goes low (B-) because the signal on line 413 was previously low, thereby making both inputs to Muller C element 420 low. The low signal on line 404.0 drives OR 418 low (E-), thereby making the signal on line 440 high, thus preparing gate 402 for another data word. Similarly the data output of Muller C element 426 goes low, as does the output of OR gate 438 (C-) on line 419. With the signal on line 419 low, the signal on line 413 is driven high by the inverter 412 (D+) at which time repeater 406 is configured to accept another data word. The timing signals shown in FIG. 5 are not to any particular scale, but do indicate the relative positions of signal edges.

Still looking to FIG. 4, during proper operation (that is, glitch-free) a valid H input to gate 406 causes the gate 406 output to provide a corresponding symbol to gate 404. An OR gate 418 receives signals from lines 404.0, 404.1, and 404.2. The output of the OR gate 418 is provided to an inverter 410. The inverter 410 output provides an acknowledgement ("ACK") signal from gate 406 back to gate 402. For example, consider 402.0 = 1, 402.1 = 402.2 = 0, such data having been previously provided to gate 406 by gate 402. OR gate 418 is driven high by the high output of gate 406 on line 406.0 while the output of inverter 412 on line 413 is low. The high output of the OR gate 418 is provided to an inverter 410 of gate 402, thereby providing an acknowledgement ("ACK") to gate 402, an indication by gate 406 that the symbol from gate 402 has been presented to gate 404. Each of the Muller C elements in the sender gate 402 correspond to the two-input Muller C element discussed earlier wherein, according to Table 1 (and equation [1] the output Q (corresponding to the signal on line 406.0) may now return to zero (implementing the RTZ requirement). We see, then, that data is passed along a bus from a sender to a receiver with optional gates in between the sender and the receiver, wherein at each stage the output of the stage provides an ACK back to the previous stage whilst passing the data on to the next stage (if any).

As the preceding discussion shows, a glitch of a certain polarity and power at a certain time and location (in the circuit) could cause a clockless circuit, to behave in the same manner as with a proper (intended) state change. Table 3 lists some errors in a self-clocking circuit that could result from a glitch. Of course the potential problems listed in Table 3 depend upon other conditions.

Table 3

| Glitch | Location | Expected Next Activity | Possible Effect |
|---|---|---|---|
| + | ACK | New 1-of-n code | Temporary lockout |
| + | ACK | ACK assertion | Symbol loss (race through) |
| + | Data line | New 1-of-n code (same line) | Additional symbol |
| + | Data line | New 1-of-n code (different line) | • Additional symbol • Illegal symbol |
| + | Data line | ACK assertion | Illegal symbol (2-of-n) |
| + | Data line | ACK de-sssertion | • Additional symbol • Illegal symbol |
| - | ACK | Code RTZ | Temporary lockout |
| - | ACK | ACK RTZ | Illegal symbol (race through) |
| - | Data line | Code RTZ (0-of-n) | Additional symbol |
| - | Data line | ACK assertion | No effect |
| - | Data line | ACK de-assertion | Additional symbol |

The present invention comprises circuit design wherein a self-timed circuit is hardened against the effect of glitches. The techniques presented here are generally independent and complementary to one-another. They may all be used together, although this may result in performance reductions and / or die area increases.

Pulses are attenuated (reduced in width) as they pass through CMOS logic gates, and this allows one to filter out glitches using a tunable delay line. The delay lines, when placed between an input wire and additional input port on a C element, results in only sustained level changes being latched, filtering out momentary glitches. The tunable nature of the delay line allows configuration of the sensitivity of the glitch filter. This technique of glitch filtering can be applied to any signals in the system, including the forward path, return path and inner operation of state machines, and can be applied to more complex m-of-n codes.

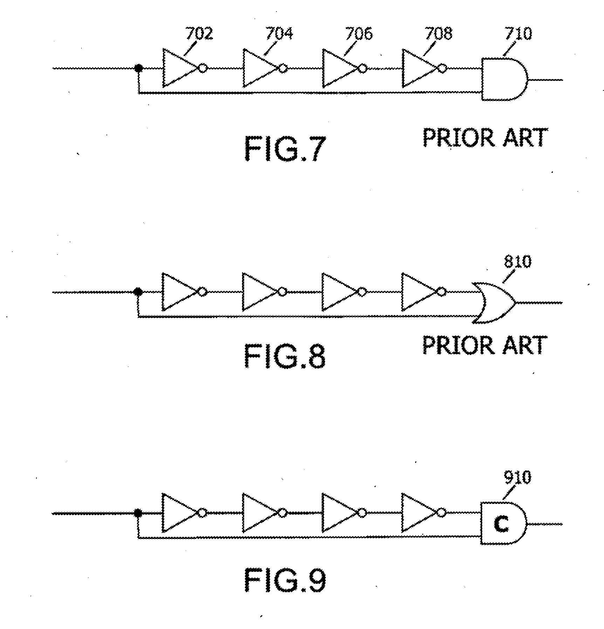

FIG. 7, 8, and 9 present three examples of delay-line glitch filters. FIG. 7 shows a glitch filter 700 comprising four inverters 702, 704, 706, and 708 in parallel with an input lead 710 to an AND gate 712. Note that the number of inverters in a delay-line glitch filter should be an even number to maintain the polarity of the glitch pulse signal. The filter 700 improves resistance to high-going glitches only. FIG. 8 shows a similar glitch filter 800 wherein AND gate 712 is replaced by an OR gate 812, thereby providing resistance to log-going glitches only.

In one embodiment filters 700 and 800 are utilized in a location within a circuit wherein mostly high-going or low-going glitches, respectively, are anticipated or where both high-going and low-going glitches are anticipated but the effect of one polarity is more problematic than the other. The benefit of protecting against only one pulse polarity is smaller footprint (die area) and less impact on performance by such a filter compared to a filter effective for both polarities.

FIG. 9 shows a glitch filter 900, effective in reducing glitches below a certain pulse width of both polarities. A (even-numbered) series of inverters (902, 904, 906, 908) is in parallel with a signal lead 910 to a Muller C element 912. As discussed previously (see Table 1) a Muller C element does not change its output unless both input signals are of the same logical value. This is true for both A=B=0 and A=B=1 ("A" corresponds to the output of the last inverter 908; "B" corresponds to the value of the signal on lead 910). Therefore the filter 900 is effective in filtering both rising and falling glitch pulses.

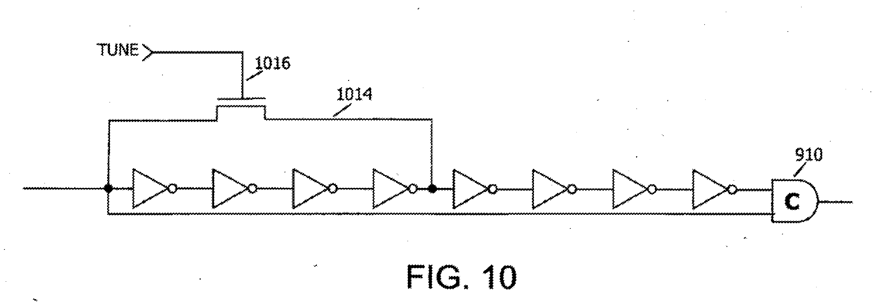

In one embodiment the delay-line flitch filters, such as filters 700, 800, and 900 are made tunable by the addition of a structure for shorting out some (even) number of the series inverters in the delay-line series inverters. FIG. 10 shows a filter similar to filter 900 with selectable pulse width filtering tuning. A signal TUNE on line 1016 turns on a pass transistor 1014, thereby reducing the number of series inverters to four versus eight. One skilled in the art will know of many alternative ways to tune the delay line. In some embodiments of the present invention tuning is determined by logic or firmware wherein a certain rate of data transmission faults determines that a longer or shorter delay time is desirable. For example, in one embodiment the delay time is increased when a system is put into low power mode, anticipating that the data rate is lower, hence the pulse width of valid signals is wider. In some embodiments a centralized monitor tracks the number and regularity of faults to provide a more adoptive glitch filtering technique to achieve a higher performance. All tunable delay lines for each transport layer component are initially tuned for high performance and if faults are detected regularly on certain routes the delay is increased for those components only.

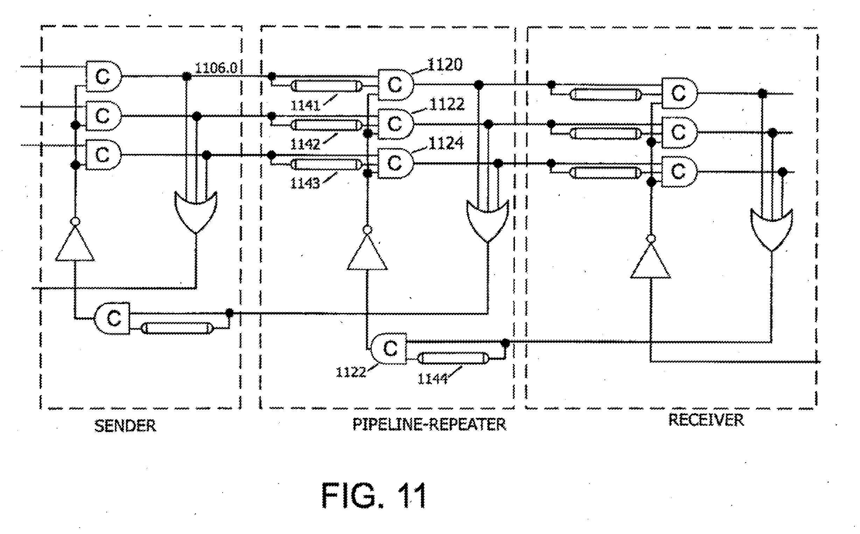

FIG. 11 is an example of glitch filters employed around the pipeline repeater 406 of FIG. 4. Delay lines 1141, 1142, and 1143 are added in parallel with the data word signal lines, Delay line 1144 is connected to the additional Muller C element 1122. Note delay lines 1141, 1142, and 1143 are connected to an additional input to a Muller C element (1120, 1122, 1124 respectively) and do not need a Muller C element (similar to element 91 in FIG. 9) as part of the delay-line filter. That is, Muller C elements 1120, 1122, 1124 are now three-input Muller C elements, requiring all three input signals to be of the same value before the C element responds. For example, a glitch on line 1106.0 will be filtered out and disregarded, providing the delay time of delay line 1141 is at least as long as the pulse width of the glitch.

Glitch filters do not have to be universally utilized. For example, in some embodiments of the present invention a non-glitch filtered hardware block is wrapped by a forward path glitch filter on its input and a return path glitch filter on its output. This hardware block wrapping can be used when the internal connections are short and assumed not to be susceptible to glitches. If the internals of hardware blocks are susceptible to glitches then the same techniques can be applied to the internal wires, on a targeted, wire by wire basis.

In one embodiment of the present invention more wires are required to level shift in order for a valid symbol to be observed and latched to further reduce the probability of a momentary glitch causing an improper/incorrect symbol. For example, a 3-of-6 configuration requires two (3-1) signals to change level prior to or in the time window of a glitch.

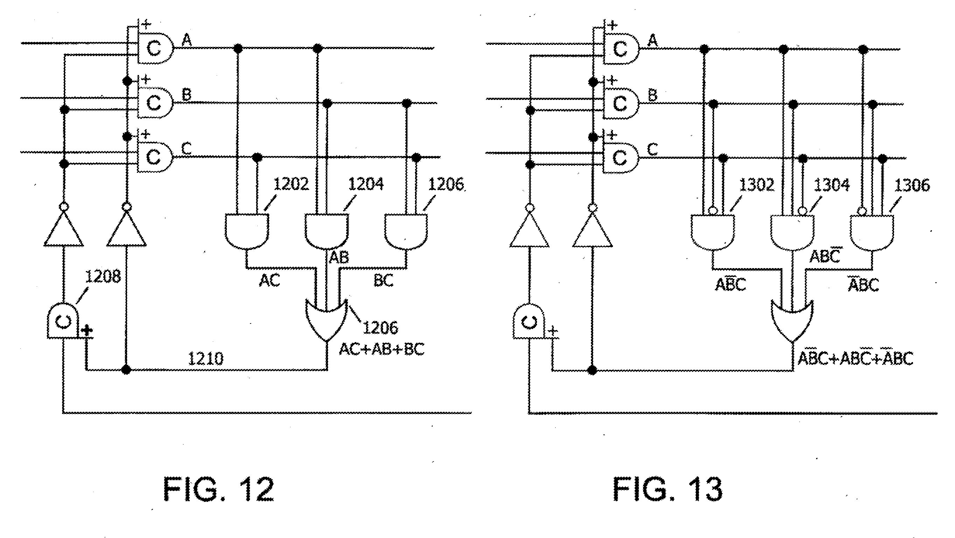

In the prior art, self-timed circuits are designed with the assumption there will be no faults. Usually an idle/low state is assumed (e.g., RTZ) and the acave/high state is explicitly detected. For example, in the circuit shown in FIG. 4 completion detection is performed by an OR gate (416, 418, 438) since the non-active inputs will be low. Similarly, for an m-of-n circuit, it is usual to detect just the 'm' active signals, assuming the (n-m) signals will be inactive. Said differently, a logical "don't care" condition is applied to the signals assumed to be inactive. FIG. 12 is an example of detecting code completion of a 2-of-3 circuit. AND gates 1202, 1204, 1206 detect all three possible valid symbols: AC, AB, and BC. Some embodiments of this approach use C-elements instead of AND gates in the design to minimize the number of timing constraints required to be met by the layout engineer creating the physical implementation. Note that in FIG. 12 (and FIG. 13) the labels A,B,C refer to the logic levels on the output lines of the Muller C elements. However this configuration would not detect the improper data word {111}, that is, A=B=C=1. The OR gate 1208 would drive a high signal on line 1210 for this improper symbol just as it would for a proper symbol. In an embodiment of the present intention all terms are evaluated to verify a proper data word / symbol. Full code-symbol detection will require more die area in that the inactive signal is adored into the detector which looks for an exact pattern on the three signal lines, but glitches could then be detected since they would cause a 3-of-3 pattern to be detected. For example, looking to FIG. 13, three three-input AND gates are used, wherein all combinations of two high and one low (that is, a 2-of-3 circuit) signals are evaluated and the OR gate 1308 only responds to proper code symbols. In one embodiment further hardening is gained by using C-elements for gates 1202, 1204, and 1206. The increase in hardening results from the Muller C behavior, wherein the ACK signal is only removed upon completion of a RTZ on the input lines.

"m-of-n" codes wherein "m" is a larger number, such as a 3-of-6 code compared to a 2-of-3 code, provide a higher data rate. That is, they are more efficient than a lower number for transmitting a given number of bits in a delay-insensitive fashion over as few wires as possible. This is normally a desirable property, but for glitch-hardening reasons, in some embodiments a slightly less efficient code is used, allowing application of a technique of trading power (energy) and area for robustness. In one embodiment of the present invention, instead of having "m" active signals in "m-of-n" encoding, there are (n-m) active signals, i.e., an "(n-m)-of-n" encoding, which as the same number of permutations and same information carrying capacity and same number of wires as the m-of-n approach.

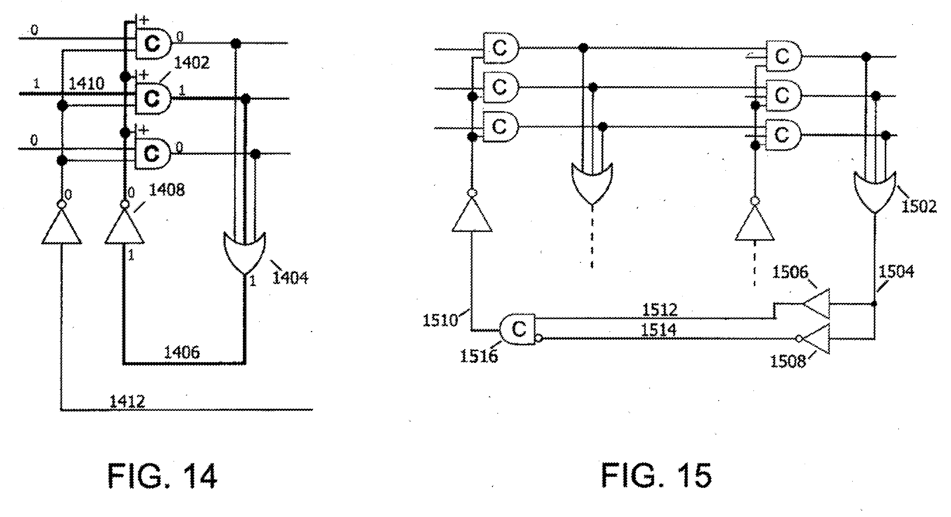

In another embodiment of the present invention a self-clocking logic block is glitch-hardened by narrowing the window of opportunity for a glitch to cause a problem. This is achieved by using the stored value propagating through a downstream latch, causing data-completion at its output, which causes assertion of an ACK, which in turn disables the original latch from being attacked by a glitch. This technique is shown in FIG. 12 and FIG. 13; refer to FIG. 14 for further discussion.

Consider an input word of {010}, wherein the high signal in line 1410 propagates to the output of the C cell 1102, thereby driving the OR gate 1404 high, signifying receipt of the data word by the block. The high OR gate 1404 signal on line 1406 is provided to an inverter 1408. The low output of inverter 1408 is provided to the input C cells, thereby locking them out from further state changes. Assuming the downstream ACK signal on line 1412 is received, when the input to the C-cells completes a RTZ, all outputs go low, as does OR 1404, thereby releasing the lockout condition. Until that time, the low output from the inverter 1408 prevents an input glitch from causing a change in output by the block.

We can improve the latch by modifying its construction to provide an explicit lockout capability, and using the local completion detector within the pipeline latch to exploit this. Doing so improves the robustness through:

Reducing the delay between storing data in the latch and locking-out hazards - lockout is very quick requiring just the propagation through a local completion detector and inverter.

Hazards on the data wires at the output of a latch can flow back through the completion-detector within the latch, causing an incorrect (advance) transition of the acknowledge wire to the upstream sender. This situation will cause the sender to block new data from entering it's latch. With a 1-of-n encoding, (or if the glitch occurs on the ACK wire with any encoding), this situation is only temporary, but with an m-of-n encoding wherein the completion detector includes a state-holding element (e.g. a C-element or SR latch) then this becomes a permanent lockout which blocks further activity. This situation can be avoided by reducing the sensitivity of each latch to rogue ACK events that occur before they are due, by the insertion of an additional asymmetric C-element or latch to lock out the acknowledge wire based on the difference between output-completion and downstream acknowledge. An example is shown in FIG. 12, wherein Muller C element 1208 includes an additional input to receive the completion signal on line 1210 from the completion detection OR gate 1212.

FIG. 15 illustrates another embodiment of the present invention wherein Muller C elements are used with complementary signaling to improve resistance to glitch-caused errors. Though the technique may be used generally, it is usually used for data lines that have long runs, such as data lines carrying ACK signals. Looking to FIG. 15, the completion detecting OR gate 1502 output signal on line 1504 is provided in parallel to a buffer 1506 and an inverter 1508. Lines 1512 and 1514 carry the complementing signals to a Muller C element 1510, wherein one of the two inputs to element 1510 includes an inverter. The output of element 1510 on line 1516 will reflect the output from the OR gate 1502 on line 1504.

The 2-of-3 protocol is the smallest, therefore cheapest, m-of-n code that allows one to apply all of the discussed fault-hardening techniques together. Of course the techniques presented in the present disclosure may be combined to a greater or lesser extent with any code protocol employing self-clocking design methodologies.

## Claims

1. A self-clocking sender circuit wherein the sender circuit comprises a plurality of Muller C elements, comprising:

   a line for carrying an output signal from each Muller C element of said sender circuit wherein each line is connected to an input terminal of a different Muller C element comprising a receiver circuit;
   a completion detection circuit which receives the sender circuit output signals as its input terminals wherein the completion detection circuit provides an output signal terminal; and
   a lockout circuit wherein the lockout circuit receives said output signal from the completion detection circuit on a line, said lockout circuit providing an output signal on a line to an input terminal on each of the plurality of Muller C elements of the sender circuit.

2. The circuit of claim 1, comprising two or more lockout circuits wherein each of said two or more lockout circuits provides an output signal on a line to an input terminal on each of the plurality of Muller C elements of the sender circuit.

3. The circuit of claim 2, wherein a least one lockout circuit comprises an inverter.

4. The circuit of claim 2, wherein at least one lockout circuit comprises:

   a Muller C element, wherein the Muller C element comprises a first input terminal for receiving a signal from the completion detection circuit and a second input terminal for receiving an acknowledgement signal from the receiver circuit; and
   an inverter in series with an output signal from the Muller C element.

5. The circuit of claim 4, wherein the Muller C element responds to a logical high signal at the first input terminal.

6. The circuit of claim 1, wherein the completion detection circuit comprises Muller C elements equal in number to the number of the sender circuit Muller C elements, wherein each of the Muller C elements of the completion detection circuit includes a number of input terminals corresponding to the number of sender circuit Muller C elements, each of said input terminals receiving an output signal from a different sender circuit Muller C element, wherein exactly one of the input terminals of each of the completion detection circuit Muller C elements an inverter for receiving and inverting said output signal from a unique sender circuit Muller C element output terminal.

7. A circuit for reducing the effect of electrical noise on a line, comprising:

a buffer including an input terminal connected to the line;
an inverter including an input terminal connected to the line in parallel with the buffer; and a Muller C element comprising:

an input terminal for receiving a signal on a line from the buffer;
an input terminal for receiving a signal on a line from the inverter;
an inverter on the input terminal corresponding to the line from the inverter; and an output terminal.

8. A circuit for hardening a self-clocking circuit wherein the self-clocking circuit comprises a plurality of Muller C elements, comprising:

a line for carrying out an output signal from each Muller C element wherein each line is connected to an output terminal of a different Muller C element;
a plurality of AND gates wherein the number of AND gates equals the number of Muller C elements and wherein the number of input terminals on each AND gate equals the number of Muller C elements;
at least one inverter on an input terminal of each AND gate, each AND gate having the same number of input terminal inverters and wherein no two AND gates have the same Muller C output signal provided to the at least one input inverter;
an OR gate for receiving output signals from of the AND gates;
an inverter for inverting an output signal from the OR gate; and
a line for carrying a signal from an output terminal of the inverter
wherein the line is connected to an input terminal of each of the Muller C elements.

FIG. 1    PRIOR ART

$$Q = A \cdot B + Q(A + B)$$

FIG. 2
PRIOR ART

FIG. 3    PRIOR ART

PRIOR ART

FIG. 4

EP 2 239 848 A2

FIG. 5

406.0 (A)

404.0 (B)

419 (C)

413 (D)

428 (E)

FIG. 6

A+ → B+ → C+ → D- → C- → D+

A+ → E+ → A- → B- → E-

FIG.7

PRIOR ART

710 708 706 704 702

FIG.8

PRIOR ART

810

FIG.9

910

FIG. 10

FIG. 11

FIG. 12

FIG. 13

EP 2 239 848 A2

FIG. 14

FIG. 15

EP 2 239 848 A2